# EUROPEAN PATENT APPLICATION

(11) **EP 3 442 044 A1**
(43) Date of publication of application: **13.02.2019**
(21) Application number: 17386026.3
(22) Date of filing: 09.08.2017
(51) Int. Cl.: H01L 51/42, H01L 27/142, H01L 31/04

(54) **CRYSTALLINE COMPOUND COMPRISING INDIUM**

(71) Applicant: Oxford University Innovation Limited, Oxford OX2 0JB (GB)
(72) Inventor: Haghighirad, Amir, Oxford, OX1 3PU (GB); Volonakis, George, Oxford, OX1 3PH (GB); Giustino, Feliciano, Oxford, OX1 3PH (GB); Snaith, Henry, Oxford, OX1 3PU (GB)
(74) Representative: J A Kemp

(57) **Abstract**

The present invention relates to a crystalline compound, which crystalline compound comprises: (i) an organic monocation; (ii) In⁺; (iii) Bi³⁺ or Sb³⁺; and (iv) a halide anion. The invention also relates to a semiconductor device comprising a semiconducting material, which semiconducting material comprises the crystalline compound. A process for producing a crystalline compound is also described.

## Description

### FIELD OF THE INVENTION

The present invention relates to a crystalline compound comprising indium which is useful as a semiconductor material or a photoactive material. The invention also relates to a semiconductor device comprising a semiconducting material, which semiconducting material comprises the crystalline compound. A process for producing the crystalline compound is also described.

### BACKGROUND OF THE INVENTION

Perovskites find applications in many areas of technology due to their remarkable structural, electronic, optical, electrical, magnetic, catalytic and superconducting properties. During the past five years hybrid organic-inorganic ABX₃ perovskites using lead (Pb) as the B-site cation and halogens (I, Br, Cl) as the X-site anions revolutionized the research on photovoltaics (Green et al, Nat. Photon. 2014, 8, 506-514.). The solar-to-electricity power conversion efficiency of devices based on (MA/FA)PbI₃ and related systems (where MA = CH₃NH₃ and FA = CH(NH₂)₂,) is currently above 22% (Seo et al, Accounts Chem. Res. 2016, 49, 562-572) and exceeds the performance of amorphous and multi-crystalline thin film silicon cells. However, lead halide perovskites tend to degrade when exposed to air, heat or humidity (Berhe et al, Energy Environ. Sci. 2016, 9, 323-356) and as a result the fabrication of solar modules containing those perovskites requires more complex encapsulation strategies than for silicon. In addition, the presence of lead in these materials raises questions on the environmental impact in view of the large-scale deployment of perovskite solar cells.

So far the quest for efficient and stable alternatives to lead-based perovskites has proven challenging (Giustino et al, ACS Energy Lett. 2016, 1, 1233-1240). For example, the substitution of Pb²⁺ by the elements Sn²⁺ or Ge²⁺ from the same group yields compounds that are unstable, with Sn and Ge preferring the +4 oxidation state (Noel et al, Energ. Environ. Sci 2014, 7, 3061). In principle, one may try to replace Pb²⁺ by other metal dications, but an extensive computational screening has shown that no other stable ABX₃ halide perovskite match the optoelectronic properties of MAPbI₃ (Filip et al, J. Phys. Chem. C 2016, 120, 166-173). More recently, the replacement of lead by two heterovalent cations in a double perovskite structure, A₂BB'X₆, has been proposed (Volonakis et al, J. Phys. Chem. Lett. 2016, 7, 1254-1259; Slavney et al, J. Am. Chem. Soc. 2016, 138, 2138-2141; McClure et al, Chem. Mater. 2016, 28, 1348-1354). To date four inorganic halide double perovskites (Cs₂BiAgCl₆, Cs₂BiAgBr₆, Cs₂InAgCl₆, Cs₂SbAgCl₆) (Filip et al, J. Phys. Chem. Lett. 2016, 7, 2579-2585; Volonakis et al, J Phys. Chem. Lett. 2017, 8, 772-778) and three hybrid halide double perovskites (MA₂BiKCl₆, MA₂BiTlBr₆, MA₂BiAgBr₆) have been synthesized (Wei et al, Mater. Horiz. 2016, 3, 328-332; Deng et al, J. Mater. Chem. A 2016, 4, 12025-12029; Wei et al, Chem. Mater. 2017, 29, 1089-1094). Recent efforts have also been devoted to mixing the B-site cations in order to achieve band gap tenability (Slavney et al, J. Am. Chem. Soc. 2017, 139, 5015-5018). Among the known stoichiometric compounds, only Cs₂InAgCl₆ and MA₂BiTlBr₆ exhibit direct band gaps. However, Cs₂InAgCl₆ has a large band gap of 3.3 eV and MA₂BiTlBr₆ contains Tl (thallium) which is toxic. These lead-free alternatives to MAPbI₃ are therefore less attractive for solar cells and optoelectronic devices.

Volonakis et al, "The Route to Stable Lead-Free Double Perovskites with the Electronic Structure of CH3NH3PbI3: A Case for Mixed-Cation [Cs/CH3NH3/CH(NH2)2]2InBiBr6", J. Phys. Chem. Letters (2017) describes the results of computational studies regarding the optoelectronic structure of indium containing materials.

There is a need to develop compounds which are useful as semiconducting materials and/or photoactive materials and which do not have the disadvantages associated with the prior art. In particular, it is desirable to identify compounds which (i) have a direct band gap, (ii) have low and balanced effective masses, (iii) have high absorption coefficient in the visible, (iv) do not contain lead (Pb) and (v) have improved stability with respect to decomposition during use.

### SUMMARY OF THE INVENTION

The inventors have surprisingly found that a new class of crystalline compounds comprising indium monocations and bismuth or antimony trications are a promising set of materials for semiconductor and optoelectronic applications. The use of an organic cation within the crystalline compound has been found to stabilise indium in the +1 oxidation state allowing for the production of stable indium/bismuth and indium/antimony semiconductors such as double perovskites. The new class of indium compounds are a stable and non-toxic alternative to lead-based semiconducting materials such as methylammonium lead triiodide.

The indium compounds identified by the inventors also have advantageous electronic and optical properties.

The invention therefore provides a crystalline compound, which crystalline compound comprises: (i) an organic monocation; (ii) In⁺; (iii) Bi³⁺ or Sb³⁺; and (iv) a halide anion.

The invention also provides a semiconductor device comprising a semiconducting material, which semiconducting material comprises a crystalline compound, which crystalline compound comprises: (i) an organic monocation; (ii) In⁺; (iii) Bi³⁺ or Sb³⁺; and (iv) a halide anion.

The invention also provides a process for producing a crystalline compound according to the invention, which process comprises contacting: (i) InX; (ii) B^{III}X'₃; and (iii) AX", wherein: each of X, X' and X" is the same or different and is a halide anion; A is an organic monocation; and B^{III} is Bi³⁺ or Sb³⁺.

### BRIEF DESCRIPTION OF THE FIGURES

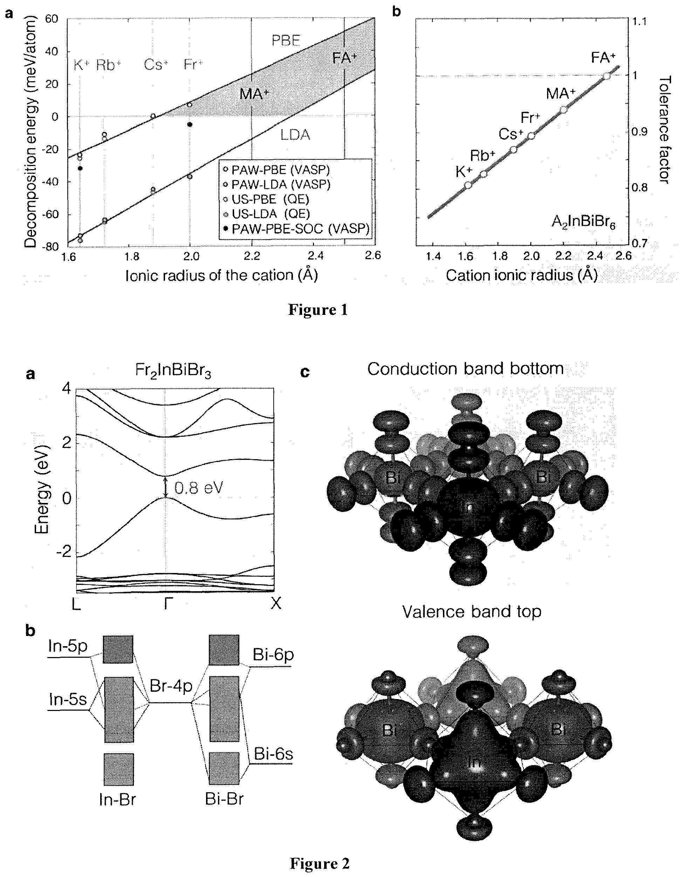

Figure 1 shows decomposition energies and tolerance factors for A₂InBiBr₆ double perovskites. (a) Decomposition energy vs. the size of the A-site cation, for the reaction A₂InBiBr₆ → 1/2 A₃In₂Br₉ + 1/6 A₃Bi₂Br₉ + 2/3 Bi. (b) Goldschmidt's tolerance factor t evaluated for cations of varying size. The dotted horizontal line shows t = 1, which corresponds to the ideal cubic perovskite structure. MA stands for methylammonium and FA is formamidinium.
Figure 2 shows electronic properties of the hypothetical cubic halide double perovskite Fr₂InBiBr₆. (a) Band structure of Fr₂InBiBr₆ using the PBE0 hybrid functional. (b) Square modulus of the electronic wavefunctions at the top of the valence band and at the bottom of the conduction band. (c) Schematic molecular orbital diagram of Fr₂InBiBr₆.

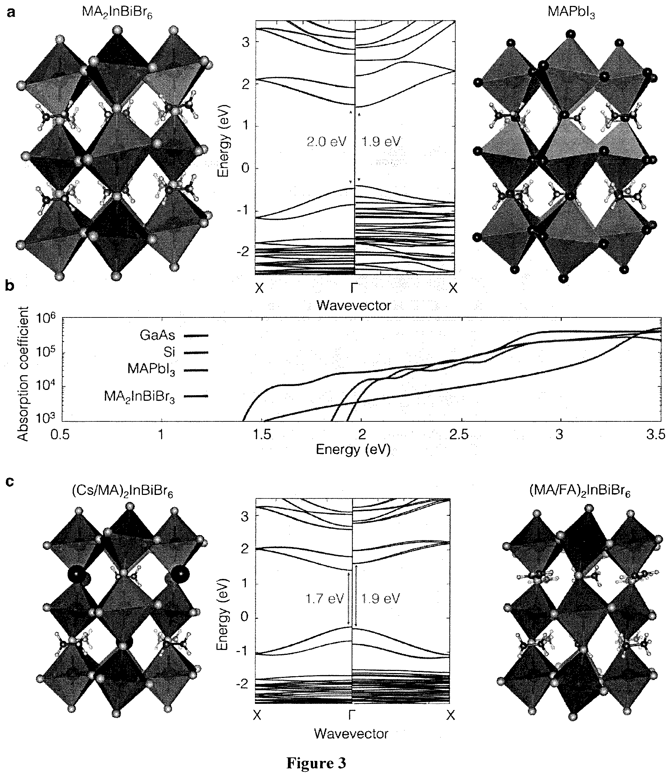

Figure 3 shows calculated electronic and optical properties of halide double perovskites MA₂InBiBr₆, (Cs/MA)₂InBiBr₆, and (MA/FA)₂InBiBr₆. (a) Ball and stick-octahedra models of the optimized structures and band structures of MA₂InBiBr₆ (left) and MAPbI₃ (right). (b) Calculated optical absorption coefficients of MA₂InBiBr₆, Si, GaAs, and MAPbI₃. (c) Same as in (a), but for (Cs/MA)₂InBiBr₆ and (MA/FA)₂InBiBr₆.

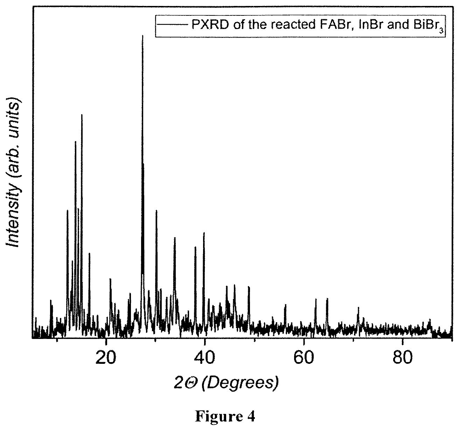

Figure 4 shows the room-temperature PXRD pattern of the product of the precursors FABr, InBr and BiBr₃ after solid-state reaction.

### DETAILED DESCRIPTION OF THE INVENTION

### Definitions

The term "crystalline compound", as used herein, refers to a compound defined by a formula comprising two or more ions, wherein the ions in the compound are arranged in an extended crystal structure. For instance, sodium chloride (NaCl) is a crystalline compound, the formula of which comprises Na⁺ and Cl⁻, and where these two ions are arranged in an extended crystal structure (the rock salt structure). Bonding between atoms and/or ions within a crystalline compound is typically intermediate between fully ionic and fully covalent bonding, although there is typically a predominance of ionic bonding. An amount of a crystalline compound typically comprises crystallites of the crystalline compound, i.e. a plurality of single crystal domains of the crystalline compound, which may be in the form of a powder or a solid. In a solid comprising a plurality of crystallites of a crystalline compound (which may be referred to as a polycrystalline solid), grain boundaries will be present between adjacent crystallites where there is a discontinuity in the extended crystal structure. A crystalline compound may be in the form of a single crystal.

The term "photoactive material", as used herein, refers to a material which either (i) absorbs light, which may then generate free charge carriers; or (ii) accepts charge, both electrons and holes, which may subsequently recombine and emit light. A photoabsorbent material is a material which absorbs light, which may then generate free charge carriers (e.g electrons and holes). Photoactive materials are examples of semiconducting materials. A photoemissive material is a material which absorbs light of energies higher than band gap and reemits light at energies at the band gap

The term "semiconductor" or "semiconducting material", as used herein, refers to a material with electrical conductivity intermediate in magnitude between that of a conductor and a dielectric. A semiconductor may be an negative (n)-type semiconductor, a positive (p)-type semiconductor or an intrinsic (i) semiconductor. A semiconducting material may have a band gap of from 0.5 to 3.5 eV, for instance from 0.5 to 2.5 eV or from 1.0 to 2.0 eV (when measured at 300 K).

The term "dielectric material", as used herein, refers to material which is an electrical insulator or a very poor conductor of electric current. The term dielectric therefore excludes semiconducting materials such as titania. The term dielectric, as used herein, typically refers to materials having a band gap of equal to or greater than 4.0 eV. (The band gap of titania is about 3.2 eV.)

The term "monocation", as used herein, refers to any cation with a single positive charge, i.e. a cation of formula A⁺ where A is any chemical moiety, for instance a metal atom or an organic moiety. The term "dication", as used herein, refers to any cation with a double positive charge, i.e. a cation of formula A²⁺ where A is any chemical moiety, for instance a metal atom. The term "trication", as used herein, refers to any cation with a triple positive charge, i.e. a cation of formula A³⁺ where A is any chemical moiety, for instance a metal atom.

The term "n-type region", as used herein, refers to a region of one or more electron-transporting (i.e. n-type) materials. Similarly, the term "n-type layer" refers to a layer of an electron-transporting (i.e. an n-type) material. An electron-transporting (i.e. an n-type) material could, for instance, be a single electron-transporting compound or elemental material. An electron-transporting compound or elemental material may be undoped or doped with one or more dopant elements.

The term "p-type region", as used herein, refers to a region of one or more hole-transporting (i.e. p-type) materials. Similarly, the term "p-type layer" refers to a layer of a hole-transporting (i.e. a p-type) material. A hole-transporting (i.e. a p-type) material could be a single hole-transporting compound or elemental material, or a mixture of two or more hole-transporting compounds or elemental materials. A hole-transporting compound or elemental material may be undoped or doped with one or more dopant elements.

The term "alkyl", as used herein, refers to a linear or branched chain saturated hydrocarbon radical. An alkyl group may be a C₁₋₂₀ alkyl group, a C₁₋₁₄ alkyl group, a C₁₋₁₀ alkyl group, a C₁₋₆ alkyl group or a C₁₋₄ alkyl group. Examples of a C₁₋₁₀ alkyl group are methyl, ethyl, propyl, butyl, pentyl, hexyl, heptyl, octyl, nonyl or decyl. Examples of C₁₋₆ alkyl groups are methyl, ethyl, propyl, butyl, pentyl or hexyl. Examples of C₁₋₄ alkyl groups are methyl, ethyl, i-propyl, n-propyl, t-butyl, s-butyl or n-butyl. If the term "alkyl" is used without a prefix specifying the number of carbons, it typically has from 1 to 6 carbons (and this also applies to any other organic group referred to herein).

The term "cycloalkyl", as used herein, refers to a saturated or partially unsaturated cyclic hydrocarbon radical. A cycloalkyl group may be a C₃₋₁₀ cycloalkyl group, a C₃₋₈ cycloalkyl group or a C₃-₆ cycloalkyl group. Examples of a C₃₋₈ cycloalkyl group include cyclopropyl, cyclobutyl, cyclopentyl, cyclohexyl, cyclohexenyl, cyclohex-1,3-dienyl, cycloheptyl and cyclooctyl. Examples of a C₃₋₆ cycloalkyl group include cyclopropyl, cyclobutyl, cyclopentyl, and cyclohexyl.

The term "aryl", as used herein, refers to a monocyclic, bicyclic or polycyclic aromatic ring which contains from 6 to 14 carbon atoms, typically from 6 to 10 carbon atoms, in the ring portion. Examples include phenyl, naphthyl, indenyl, indanyl, anthrecenyl and pyrenyl groups. The term "aryl group", as used herein, includes heteroaryl groups. The term "heteroaryl", as used herein, refers to monocyclic or bicyclic heteroaromatic rings which typically contains from six to ten atoms in the ring portion including one or more heteroatoms. A heteroaryl group is generally a 5- or 6-membered ring, containing at least one heteroatom selected from O, S, N, P, Se and Si. It may contain, for example, one, two or three heteroatoms. Examples of heteroaryl groups include pyridyl, pyrazinyl, pyrimidinyl, pyridazinyl, furanyl, thienyl, pyrazolidinyl, pyrrolyl, oxazolyl, oxadiazolyl, isoxazolyl, thiadiazolyl, thiazolyl, isothiazolyl, imidazolyl, pyrazolyl, quinolyl and isoquinolyl.

The term "substituted", as used herein in the context of substituted organic groups, refers to an organic group which bears one or more substituents selected from C₁₋₁₀ alkyl, aryl (as defined herein), cyano, amino, nitro, C₁₋₁₀ alkylamino, di(C₁₋₁₀)alkylamino, arylamino, diarylamino, aryl(C₁₋₁₀)alkylamino, amido, acylamido, hydroxy, oxo, halo, carboxy, ester, acyl, acyloxy, C₁₋₁₀ alkoxy, aryloxy, halo(C₁₋₁₀)alkyl, sulfonic acid, thiol, C₁₋₁₀ alkylthio, arylthio, sulfonyl, phosphoric acid, phosphate ester, phosphonic acid and phosphonate ester. Examples of substituted alkyl groups include haloalkyl, perhaloalkyl, hydroxyalkyl, aminoalkyl, alkoxyalkyl and alkaryl groups. When a group is substituted, it may bear 1, 2 or 3 substituents. For instance, a substituted group may have 1 or 2 substitutents.

The term "porous", as used herein, refers to a material within which pores are arranged. Thus, for instance, in a porous scaffold material the pores are volumes within the scaffold where there is no scaffold material. The individual pores may be the same size or different sizes. The size of the pores is defined as the "pore size". The limiting size of a pore, for most phenomena in which porous solids are involved, is that of its smallest dimension which, in the absence of any further precision, is referred to as the width of the pore (i.e. the width of a slit-shaped pore, the diameter of a cylindrical or spherical pore, etc.). To avoid a misleading change in scale when comparing cylindrical and slit-shaped pores, one should use the diameter of a cylindrical pore (rather than its length) as its "pore-width" (J. Rouquerol et al., "Recommendations for the Characterization of Porous Solids", Pure & Appl. Chem., Vol. 66, No. 8, pp.1739-1758, 1994). The following distinctions and definitions were adopted in previous IUPAC documents (K.S.W. Sing, et al. Pure and Appl. Chem., vol.57, n04, pp 603-919, 1985; and IUPAC "Manual on Catalyst Characterization", J. Haber, Pure and Appl. Chem., vol.63, pp. 1227-1246, 1991): micropores have widths (i.e. pore sizes) smaller than 2 nm; Mesopores have widths (i.e. pore sizes) of from 2 nm to 50 nm; and Macropores have widths (i.e. pore sizes) of greater than 50 nm. In addition, nanopores may be considered to have widths (i.e. pore sizes) of less than 1 nm.

Pores in a material may include "closed" pores as well as open pores. A closed pore is a pore in a material which is a non-connected cavity, i.e. a pore which is isolated within the material and not connected to any other pore and which cannot therefore be accessed by a fluid (e.g. a liquid, such as a solution) to which the material is exposed. An "open pore" on the other hand, would be accessible by such a fluid. The concepts of open and closed porosity are discussed in detail in J. Rouquerol et al., "Recommendations for the Characterization of Porous Solids", Pure & Appl. Chem., Vol. 66, No. 8, pp.1739-1758, 1994.

Open porosity, therefore, refers to the fraction of the total volume of the porous material in which fluid flow could effectively take place. It therefore excludes closed pores. The term "open porosity" is interchangeable with the terms "connected porosity" and "effective porosity", and in the art is commonly reduced simply to "porosity".

The term "without open porosity", as used herein, therefore refers to a material with no effective open porosity. Thus, a material without open porosity typically has no macropores and no mesopores. A material without open porosity may comprise micropores and nanopores, however. Such micropores and nanopores are typically too small to have a negative effect on a material for which low porosity is desired.

The term "compact layer", as used herein, refers to a layer without mesoporosity or macroporosity. A compact layer may sometimes have microporosity or nanoporosity.

The terms "semiconductor device" or "semiconducting device", as used herein, refers to a device comprising a functional component which comprises a semiconducting material. Examples of semiconductor devices include a photovoltaic device, a solar cell, a photo detector, a photodiode, a photosensor, a chromogenic device, a transistor, a light-sensitive transistor, a phototransistor, a solid state triode, a battery, a battery electrode, a capacitor, a super-capacitor, a light-emitting device and a light-emitting diode. The term "optoelectronic device", as used herein, refers to devices which source, control, detect or emit light. Light is understood to include any electromagnetic radiation. Examples of optoelectronic devices include photovoltaic devices, photodiodes (including solar cells), phototransistors, photomultipliers, photoresistors, light emitting devices, light emitting diodes and charge injection lasers.

The term "consisting essentially of" refers to a composition comprising the components of which it consists essentially as well as other components, provided that the other components do not materially affect the essential characteristics of the composition. Typically, a composition consisting essentially of certain components will comprise greater than or equal to 95 wt% of those components or greater than or equal to 99 wt% of those components.

### Crystalline compound

The invention provides a crystalline compound, which crystalline compound comprises: (i) an organic monocation; (ii) In⁺; (iii) Bi³⁺ or Sb³⁺; and (iv) a halide anion. Thus, the crystalline compound has a formula which includes each of the ions in (i) to (iv).

Organic monocations are typically monocations comprising at least one carbon atom and at least one hydrogen atom. Often, organic monocations comprise a hydrogen atom bonded to a carbon atom (for instance in methylammonium, CH₃NH₃⁺), but also in some cases do not (for instance in guanidinium, C(NH₂)₃⁺). Typically, the organic monocation comprises at least one carbon atom, at least one hydrogen atom and at least one nitrogen cation. For instance, the organic monocation may be an organic ammonium monocation.

The crystalline compound typically comprises: (i) one or more first monocations [A], which one or more first monocations comprise the organic monocation; (ii) one or more second monocations [B^{I}], which one or more second monocations comprise In⁺; (iii) one or more trications [B^{III}], which one or more trications comprise Bi³⁺ or Sb³⁺; and (iv) one or more halide anions [X].

For instance, [A] may comprise the organic monocation and zero, one, two or three different first monocations. [B^{I}] may comprise In⁺ and zero, one, two or three different second monocations. [B^{III}] may comprise Bi³⁺ or Sb³⁺ and zero, one, two or three different trications. [X] may be one, two, three or four different halide anions.

For instance, if [A] is two first monocations (A¹ and A²), [B^{I}] is one second monocation (In⁺), [B^{III}] is one trication (B^{III}) and [X] is one halide anion (X), the crystalline material may comprise a compound of formula (A¹,A²)ₐIn_{bI}B^{III}b_{III}X_{c}, where a, bI, bIII and c are integers from 1 to 10. If [A], [B^{I}], [B^{III}] or [X] is more than one ion, those ions may be present in any proportion. For instance, (A¹, A²)ₐIn_{bI}B^{III}_{bIII}X_{c} includes all compounds of formula A¹_{ya}A²_{(1-y)a}B^{I}b_{I}B^{III}_{bIII}X_{c} wherein y is between 0 and 1, for instance from 0.05 to 0.95. Such materials may be referred to as mixed ion materials (for instance a mixed cation material). In such mixed ion materials, the two ions which are mixed (e.g. A¹ and A²) may be distributed across the sites for those ions in an ordered or disordered manner.

The crystalline compound may be a mixed cation crystalline compound which comprises: (i) Cs⁺; (ii) (CH₃NH₃)⁺ and/or (H₂N-C(H)=NH₂)⁺; (iii) In⁺; (iv) Bi³⁺ or Sb³⁺; and (v) a halide anion.

In addition to In⁺, the one or more second monocations [B^{I}] may comprise one or more further metal and metalloid monocations. For instance, the one or more second monocations [B^{I}] may comprise In⁺ and one or more of Cu⁺, Ag⁺, Au⁺ and Hg⁺.

In addition to Bi³⁺ and/or Sb³⁺, the one or more trications [B^{III}] may comprise one or more further metal and metalloid trications. For instance, the one or more trications [B^{III}] may comprise Bi³⁺ and/or Sb³⁺ and one or more of Cr³⁺, Fe³⁺, Co³⁺, Ga³⁺, As³⁺, Ru³⁺, Rh³⁺, Ir³⁺ and Au³⁺.

The one or more first monocations [A] are typically selected from Cs⁺, (NR¹R²R³R⁴)⁺, (R¹R²N=CR³R⁴)⁺, (R¹R²N-C(R⁵)=NR³R⁴)⁺ and (R¹R²N-C(NR⁵R⁶)=NR³R⁴)⁺, wherein each of R¹, R², R³, R⁴, R⁵ and R⁶ is independently H, a substituted or unsubstituted C₁₋₂₀ alkyl group or a substituted or unsubstituted aryl group. Typically, each of R¹, R², R³, R⁴, R⁵ and R⁶ is independently H, methyl, hydroxymethyl, ethyl, n-propyl, isopropyl, phenyl, methylphenyl (-Ph-CH₃), ethylphenyl (-Ph-CH₂CH₃), benzyl (-CH₂-Ph) or phenylethyl (-CH₂CH₂-Ph). Often, each of R¹, R², R³, R⁴, R⁵ and R⁶ is independently H or methyl.

For instance, the one or more first monocations [A] may be selected from (CH₃NH₃)⁺, (CH₃CH₂NH₃)⁺, (H₂N-C(H)=NH₂)⁺ and (H₂N-C(NH₂)=NH₂)⁺.

Preferably, the one or more trications [B^{III}] comprise Bi³⁺. The one or more trications may comprise a single trication which is Bi³⁺.

Typically, the one or more halide anions [X] are selected from I⁻, Br⁻ and Cl⁻. Preferably, the one or more halide anions [X] are a single halide anion which is Br⁻. The crystalline compound may be a mixed halide compound, for instance wherein the one or more halide anions [X] comprise Br⁻ and Cl⁻ or wherein he one or more halide anions [X] comprise Br⁻ and I⁻.

Thus, the crystalline compound may comprise (i) an organic monocation; (ii) In⁺; (iii) Bi³⁺; and (iv) Br⁻.

The compound typically adopts a structure related to the perovskite structure, and in particular a double perovskite structure or a layered double perovskite structure. The term "perovskite", as used herein, refers to a material with a three-dimensional crystal structure related to that of CaTiO₃ or a material comprising a layer of material, which layer has a structure related to that of CaTiO₃. The structure of CaTiO₃ can be represented by the formula ABX₃, wherein A and B are cations of different sizes and X is an anion. In the unit cell, the A cations are at (0,0,0), the B cations are at (1/2, 1/2, 1/2) and the X anions are at (1/2, 1/2, 0). In a double perovskite structure, the compound is represented by the formula AB^{I}_{0.5}B^{III}_{0.5}X₃ (equivalent to A₂B^{I}B^{III}X₆) and half of the B sites at (1/2, 1/2, 1/2) are occupied by B^{I} monocations (e.g. In⁺) and the other half of the B sites are occupied by B^{III} trications. The occupation of the B sites by the B^{I} and B^{III} cations may be ordered or disordered. Typically, the arrangement of the B^{I} and B^{III} cations in the B sites on the lattice are ordered. Often, the B^{I} and B^{III} cations in the B sites on the lattice are arranged in a "chequerboard" fashion with B^{I} and B^{III} cations alternating along each of the three axes of the lattice. A layered double perovskite has a structure comprising layers of the double perovskite structure and may, for instance have the formula A₂B^{I}_{0.5}B^{III}_{0.5}X₄ (equivalent to A₄B^{I}B^{III}X₈).

Typically, the crystalline compound is a compound of formula (I):

[A]₂[B^{I}][B^{III}][X]₆ (I);

wherein:
[A] is the one or more first monocations;
[B^{I}] is the one or more second monocations;
[B^{III}] is the one or more trications; and
[X] is the one or more halide anions.

The crystalline compound may be a mixed cation crystalline compound which comprises two or three first monocations. For instance, the crystalline compound may be a compound of formula (Ia):

(A'ₓA"_{y}A"'_{(1-x-y)})₂InSb_{q}Bi_{(1-q)}[X]₆ (Ia);

wherein:
A' is the organic monocation;
A" is a first further monocation;
A"' is a second further monocation;
x is from 0.1 to 1.0;
y is from 0.0 to 1.0;
x + y is less than or equal to 1.0;
q is from 0.0 to 1.0; and
[X] is the one or more halide anions.

For instance, A' may be (CH₃NH₃)⁺, A" may be (H₂N-C(H)=NH₂)⁺ and A''' may be Cs⁺. The crystalline compound may therefore be a compound of formula ((CH₃NH₃)ₓ(H₂N-C(H)=NH₂)_{y}Cs_{(1-x-y)})₂InBiBr₆.

In mixed cation materials, x and y are typically each independently from 0.3 to 0.7. x may be from 0.1 to 0.4, for instance from 0.2 to 0.3. Alternatively, x may be from 0.6 to 0.9, for instance from 0.7 to 0.8. y may be from 0.1 to 0.4, for instance from 0.2 to 0.3. Alternatively, y may be from 0.6 to 0.9, for instance from 0.7 to 0.8. (1-x-y) may for instance be from 0.3 to 0.7.
q is typically 0.0 or 1.0, but may be from 0.1 to 0.9 in mixed trication materials. Examples of the crystalline compound therefore include: ((CH₃NH₃)_{0.2}(H₂N-C(H)=NH₂)_{0.2}Cs_{0.6})₂InBiBr₆, ((CH₃NH₃)_{0.4}(H₂N-C(H)=NH₂)_{0.2}Cs_{0.4})InBiBr₆, ((CH₃NH₃)_{0.2}(H₂N-C(H)=NH₂)_{0.4}Cs_{0.4})₂InBiBr₆, ((CH₃NH₃)_{0.4}(H₂N-C(H)=NH₂)_{0.4}Cs_{0.2})₂InBiBr₆, ((CH₃NH₃)_{0.6}(H₂N-C(H)=NH₂)_{0.3}Cs_{0.1})₂InBiBr₆, and ((CH₃NH₃)_{0.3}(H₂N-C(H)=NN₂)_{0.6}Cs_{0.1})₂InBiBr₆.

The crystalline compound may comprise two different first monocations. For instance, the crystalline compound may be a compound of formula (Ib):

(A'ₓA"₍₁₋ₓ₎)₂InSb_{q}Bi_{(1-q)}[X]₆ (Ib);

wherein:
A' is the organic monocation;
A" is a further monocation;
x is from 0.1 to 1.0;
q is from 0.0 to 1.0; and
[X] is the one or more halide anions.

Typically, the further monocation is Cs⁺, NH₄⁺, (CH₃NH₃)⁺ or (H₂N-C(H)=NH₂)⁺. x may be from 0.2 to 0.8. For instance, x may be from 0.2 to 0.3 or from 0.7 to 0.8. q is typically 0.0 or 1.0, but may be from 0.1 to 0.9 in mixed trication materials.

For instance, the crystalline compound may be ((H₂N-C(H)=NH₂)ₓCs₍₁₋ₓ₎)₂InBiBr₆ or ((CH₃NH₃)ₓCs₍₁₋ₓ₎)₂InBiBr₆ where x is from 0.1 to 1.0. Examples of the crystalline compound therefore include: ((H₂N-C(H)=NH₂)_{0.9}Cs_{0.1})₂InBiBr₆, ((H₂N-C(H)=NH₂)_{0.8}Cs_{0.2})₂InBiBr₆, ((H₂N-C(H)=NH₂)_{0.7}Cs_{0.3})₂InBiBr₆, ((H₂N-C(H)=NH₂)_{0.6}Cs_{0.4})₂InBiBr₆, ((H₂N-C(H)=NH₂)_{0.5}Cs_{0.5})₂InBiBr₆, ((H₂N-C(H)=NH₂)_{0.4}Cs_{0.6})₃InBiBr₆, ((H₂N-C(H)=NH₂)_{0.3}Cs_{0.7})₂InBiBr₆, ((CH₃NH₃)_{0.9}Cs_{0.1})₂InBiBr₆, ((CH₃NH₃)_{0.8}Cs_{0.2})₂InBiBr₆, ((CH₃NH₃)_{0.7}Cs_{0.3})₂InBiBr₆, ((CH₃NH₃)_{0.6}Cs_{0.4})₂InBiBr₆, ((CH₃NH₃)_{0.5}CS_{0.5})₂InBiBr₆, ((CH₃NH₃)_{0.4}Cs_{0.6})₂InBiBr₆, ((CH₃NH₃)_{0.3}CS_{0.7})₂InBiBr₆, ((CH₃NH₃)_{0.2}Cs_{0.8})₂InBiBr₆ and ((CH₃NH₃)_{0.1}Cs_{0.9})₂InBiBr₆.

Typically, the compound is a compound of formula (Ic):

A₂InB^{III}[X]₆ (Ic);

wherein:
A is the organic monocation;
B^{III} is Bi³⁺ or Sb³⁺; and
[X] is the one or more halide anions.

If [X] is two or more halide anions, the crystalline compound may be a mixed halide double perovskite compound of formula (Id):

A₂InB^{III}(X₍₁₋ₓ₎X'ₓ)₆ (Id);

wherein: A is the organic monocation; B^{III} is Bi³⁺ or Sb³⁺; X is a halide anion; X' is a different halide anion; and x is from 0.01 to 0.99, for instance from 0.05 to 0.95 or from 0.2 to 0.8.

Examples of mixed halide compounds according to the invention include A₂InBi(Br₍₁₋ₓ₎Iₓ)₆ and A₂InBi(Br₍₁₋ₓ₎Clₓ)₆ where x is from 0.1 to 0.9 and A is (CH₃NH₃)⁺ or (H₂N-C(H)=NH₂)⁺. x may for instance be from 0.1 to 0.3.

Often, however, the compound is a single halide double perovskite compound of formula (Ie):

A₂InB^{III}X₆ (Ie);

wherein: A is the organic monocation; B^{III} is Bi³⁺ or Sb³⁺; and X is one halide anion, preferably Br⁻.

The crystalline compound may be (H₂N-C(H)=NH₂)₂InBiI₆, (H₂N-C(H)=NH₂)₂InSbI₆, (H₂N-C(H)=NH₂)₂InBiBr₆, (H₂N-C(H)=NH₂)₂InSbBr₆, (H₂N-C(H)=NH₂)₂InBiCl₆, (H₂N-C(H)=NH₂)₂InSbCl₆, (CH₃NH₃)₂InBiI₆, (CH₃NH₃)₂InSbI₆, (CH₃NH₃)₂InBiBr₆, (CH₃NH₃)₂InSbBr₆, (CH₃NH₃)₂InBiCl₆ or (CH₃NB₃)₂]nSbCl₆. For instance, the crystalline compound may be (H₂N-C(H)=NH₂)₂InBiBr₆ or (CH₃NH₃)₂InBiBr₆.

In some cases, the crystalline compound is a layered compound. For instance, the crystalline compound may be a compound of formula (II):

[A]₄[B^{I}][B^{III}][X]₈ (II);

wherein: [A] is the one or more first monocations; [B^{I}] is the one or more second monocations; [B^{III}] is the one or more trications; and [X] is the one or more halide anions. A, B^{I}, B^{III} and X may be as defined herein.

The crystalline compound may additionally comprise a dication. For instance, the crystalline compound may be a compound of formula (III):

[A]₂[B^{I}]_{(2-z)/2}[B^{II}]_{z}[B^{III}]]_{(2-z})_{/2}[X]₆ (III);

wherein: [A] is the one or more first monocations; [B^{I}] is the one or more second monocations; [B^{II}] is one or more metal dications, [B^{III}] is the one or more trications; [X] is the one or more halide anions; and z is from 0.01 to 1.99. z may be from 0.2 to 1.8, for instance from 0.5 to 1.5. The one or more metal dications are typically selected from Pb²⁺, Sn²⁺ and Ge²⁺. For instance, the one or more metal dications may be Pb²⁺. For instance, the compound of the invention may be A₂In_{(2-z)/2}Pb_{z}B^{III}_{(2-z)/2}X₆ where A is (H₂N-C(H)=NH₂)⁺ or (CH₃NH₃)⁺, B^{III} is Bi³⁺ or Sb³⁺.

The invention also provides a semiconducting material comprising a crystalline compound as defined herein. The semiconducting material typically comprises at least 80% by weight of the crystalline compound. The semiconducting material may comprises at least 90% by weight of the crystalline compound. For instance the semiconducting material may consist essentially of the crystalline compound.

Typically, the semiconducting material is in the form of a layer of the semiconducting material. The layer may have a thickness of from 5 nm to 5000 nm, for instance from 5 nm to 1500 nm. The thickness of the layer may be from 100 to 700 nm.

### Semiconductor device

The invention also provides a semiconductor device comprising a semiconducting material, which semiconducting material comprises a crystalline compound, which crystalline compound comprises: (i) an organic monocation; (ii) In⁺; (iii) Bi³⁺ or Sb³⁺; and (iv) a halide anion.

The semiconductor device is typically an optoelectronic device. Preferably, the semiconductor device is a photovoltaic device, a photodetector or a light-emitting device. More preferably, the semiconductor device is a photovoltaic device (for instance a solar cell).

The semiconductor device typically comprises a layer of the semiconducting material. The layer of the semiconducting material typically comprises greater than or equal to 50 % by weight or greater than or equal to 80 % by weight to the crystalline compound. The layer of the semiconducting material may consist, or consist essentially of (e.g. greater than or equal to 99 wt%) a layer of the crystalline compound.

The layer of said semiconducting material may for instance have a thickness of from 5 nm to 10000 nm. Typically, the semiconductor device comprises a layer of the semiconducting material, which layer preferably has a thickness of from 5 nm to 5000 nm, for instance from 5 to 1500 nm. Preferably, the layer of the semiconducting material has a thickness of from 100 nm to 700 nm, for instance from 200 nm to 500 nm. In some devices, the layer may be a thin sensitising layer, for instance having a thickness of from 5 nm to 50 nm. In devices wherein the layer of said semiconducting material forms a planar heterojunction with an n-type or p-type region, the layer of said photoactive material may have a thickness of greater than or equal to 100 nm. Preferably, the layer of said photoactive material has a thickness of from 100 nm to 700 nm, for instance from 200 nm to 500 nm.

Typically, the semiconductor device comprises: an n-type region comprising at least one n-type layer; a p-type region comprising at least one p-type layer; and, disposed between the n-type region and the p-type region: a layer of said semiconducting material. An n-type layer is typically a layer of an n-type semiconductor. A p-type layer is typically a layer of a p-type semiconductor.

The n-type region comprises at least one n-type layer. The n-type region may comprise an n-type layer and an n-type exciton blocking layer. Such an n-type exciton blocking layer is typically disposed between the n-type layer and the layer(s) comprising the semiconducting material. The n-type region may have a thickness of from 50 nm to 1000 nm. For instance, the n-type region may have a thickness of from 50 nm to 500 nm, or from 100 nm to 500 nm.

Preferably, the n-type region comprises a compact layer of an n-type semiconductor.

The n-type semiconductor may be selected from a metal oxide, a metal sulphide, a metal selenide, a metal telluride, a perovskite, amorphous Si, an n-type group IV semiconductor, an n-type group III-V semiconductor, an n-type group II-VI semiconductor, an n-type group I-VII semiconductor, an n-type group IV-VI semiconductor, an n-type group V-VI semiconductor, and an n-type group II-V semiconductor, any of which may be doped or undoped. Typically, the n-type semicondcutor is selected from a metal oxide, a metal sulphide, a metal selenide, and a metal telluride. For instance, the n-type region may comprise an inorganic material selected from oxide of titanium, tin, zinc, niobium, tantalum, tungsten, indium, gallium, neodymium, palladium, or cadmium, or an oxide of a mixture of two or more of said metals. For instance, the n-type layer may comprise TiO₂, SnO₂, ZnO, Nb₂O₅, Ta₂O₅, WO₃, W₂O₅, In₂O₃, Ga₂O₃, Nd₂O₃, PbO, or CdO.

Typically, the n-type region comprises SnO₂ or TiO₂, for instance a compact layer of TiO₂ or SnO₂. Often, the n-type region also comprises a layer of a fullerene or a fullerene derivative (for instance C₆₀ or Phenyl-C61-butyric acid methyl ester (PCBM)).

The p-type region comprises at least one p-type layer. The p-type region may comprise an p-type layer and a p-type exciton blocking layer. Such a p-type exciton blocking layer is typically disposed between the p-type layer and the layer(s) comprising the semiconducting material. The p-type region may have a thickness of from 50 nm to 1000 nm. For instance, the p-type region may have a thickness of from 50 nm to 500 nm, or from 100 nm to 500 nm.

Preferably, the p-type region comprises a compact layer of a p-type semiconductor

Suitable p-type semiconductors may be selected from polymeric or molecular hole transporters. The p-type layer employed in the semiconductor device of the invention may for instance comprise spiro-OMeTAD (2,2',7,7'-tetrakis-(N,N-di-p-methoxyphenylamine)9,9'-spirobifluorene)), P3HT (poly(3-hexylthiophene)), PCPDTBT (Poly[2,1,3-benzothiadiazole-4,7-diyl[4,4-bis(2-ethylhexyl)-4H-cyclopenta[2,1-b:3,4-b']dithiophene-2,6-diyl]]), PVK (poly(N-vinylcarbazole)), HTM-TFSI (1-hexyl-3-methylimidazolium bis(trifluoromethylsulfonyl)imide), Li-TFSI (lithium bis(trifluoromethanesulfonyl)imide) or tBP (tert-butylpyridine). The p-type region may comprise carbon nanotubes. Usually, the p-type material is selected from spiro-OMeTAD, P3HT, PCPDTBT and PVK. Preferably, the p-type layer employed in the optoelectronic device of the invention comprises spiro-OMeTAD.

In some embodiments, the p-type layer may comprise an inorganic hole transporter. For instance, the p-type layer may comprise an inorganic hole transporter comprising an oxide of nickel, vanadium, copper or molybdenum; CuI, CuBr, CuSCN, Cu₂O, CuO or CIS; a perovskite; amorphous Si; a p-type group IV semiconductor, a p-type group III-V semiconductor, a p-type group II-VI semiconductor, a p-type group I-VII semiconductor, a p-type group IV-VI semiconductor, a p-type group V-VI semiconductor, and a p-type group II-V semiconductor, which inorganic material may be doped or undoped. The p-type layer may be a compact layer of said inorganic hole transporter.

The layer of the semiconducting material typically forms a planar heterojunction with the n-type region or the p-type region. The layer of the semiconducting material typically forms a first planar heterojunction with the n-type region and a second planar heterojunction with the p-type region. This forms a planar heterojunction device. The term "planar heterojunction" as used herein refers to a junction between two regions where one region does not infiltrate the other. This does not require that the junction is completely smooth, just that one region does not substantially infiltrate pores in the other region.

In some embodiments, it is desirable to have a porous scaffold material present. The layer of a porous scaffold is usually in contact with a compact layer of a semiconductor material, for instance an n-type compact layer or a p-type compact layer. The layer of a porous scaffold is usually also in contact with the semiconducting material. The scaffold material is typically mesoporous or macroporous. The scaffold material may aid charge transport from the semiconducting material to an adjacent region. The scaffold material may also, or alternatively, aid formation of the layer of the semiconducting material during device construction. The porous scaffold material is typically infiltrated by the semiconducting material.

Thus, in some embodiments, the semiconductor device comprises:
an n-type region comprising at least one n-type layer;
a p-type region comprising at least one p-type layer; and, disposed between the n-type region and the p-type region:
   (i) a porous scaffold material; and
   (ii) said semiconducting material in contact with the scaffold material.

If a scaffold material is present, the semiconducting material in the first layer is typically disposed in pores of the scaffold material. The scaffold material is typically mesoporous. The scaffold material may be macroporous.

Typically, the porous scaffold material comprises a dielectric material or a charge-transporting material. The porous scaffold material may be an electron-transporting material or a hole-transporting scaffold material. n-type semiconducting materials are examples of electron-transporting materials. p-type semiconductors are examples of hole-transporting scaffold materials. Preferably, the porous scaffold material is a dielectric scaffold material, for instance alumina. The porous scaffold material may be an electron-transporting scaffold material, for instance titania.

The porous scaffold is typically in the form of a layer. For instance, the porous scaffold may be a layer of porous scaffold material, typically having a thickness of from 5 nm to 500 nm, for instance from 10 nm to 200 nm.

In some embodiments, the semiconductor device comprises:
an n-type region comprising at least one n-type layer;
a p-type region comprising at least one p-type layer; and, disposed between the n-type region and the p-type region:
   (i) a first layer which comprises a porous scaffold material and said semiconducting material; and
   (ii) a capping layer disposed on said first layer, which capping layer is a layer of said semiconducting material without open porosity,
wherein the semiconducting material in the capping layer is in contact with the semiconducting material in the first layer.

In some embodiments, the scaffold material is porous and the semiconducting material in the first layer is disposed in pores of the scaffold material. The effective porosity of said scaffold material is usually at least 50%. For instance, the effective porosity may be about 70%. In one embodiment, the effective porosity is at least 60%, for instance at least 70%.

Typically, the semiconducting material (or photoactive material) in the first layer contacts one of the p-type and n-type regions, and the semiconducting material in the capping layer contacts the other of the p-type and n-type regions. The semiconducting material in the capping layer typically forms a planar heterojunction with the p-type region or the n-type region.

In one embodiment, the semiconducting material in the capping layer contacts the p-type region, and the semiconducting material in the first layer contacts the n-type region. In another embodiment, the semiconducting material in the capping layer contacts the n-type region, and the semiconducting material in the first layer contacts the p-type region (for instance in an inverted device).

The thickness of the capping layer is usually greater than the thickness of the first layer. The majority of any photoactivity (e.g. light absorption or light emission) therefore usually occurs in a capping layer.

The thickness of the capping layer is typically from 10 nm to 100 µm. More typically, the thickness of the capping layer is from 10 nm to 10 µm. Preferably, the thickness of the capping layer is from 50 nm to 1000 nm, or for instance from 100 nm to 700 nm. The thickness of the capping layer may be greater than or equal to 100 nm. The thickness of the first layer, on the other hand, is often from 5 nm to 1000 nm. More typically, it is from 5 nm to 500 nm, or for instance from 30 nm to 200 nm.

The semiconductor device typically further comprises one or more first electrodes and one or more second electrodes. The one or more first electrodes are typically in contact with the n-type region, if such a region is present. The one or more second electrodes are typically in contact with the p-type region, if such a region is present. Typically: the one or more first electrodes are in contact with the n-type region and the one or more second electrodes are in contact with the p-type region; or the one or more first electrodes are in contact with the p-type region and the one or more second electrodes are in contact with the n-type region.

The first and second electrode may comprise any suitable electrically conductive material. The first electrode typically comprises a transparent conducting oxide. The second electrode typically comprises one or more metals. The second electrode may alternatively comprise graphite. Typically, the first electrode typically comprises a transparent conducting oxide and the second electrode typically comprises one or more metals.

The transparent conducting oxide typically comprises fluorine-doped tin oxide (FTO), indium tin oxide (ITO) or aluminium-doped zinc oxide (AZO), and typically ITO. The second electrode typically comprises a metal selected from silver, gold, copper, aluminium, platinum, palladium, or tungsten. Each electrode may form a single layer or may be patterned.

The semiconductor device (for instance a photovoltaic device) may comprise the following layers in the following order:
I. one or more first electrodes as defined herein;
II. an n-type region comprising at least one n-type layer as defined herein;
III. a layer of the semiconducting material comprising the crystalline compound as defined herein;
IV. a p-type region comprising at least one p-type layer as defined herein; and
V. one or more second electrodes as defined herein.

The semiconductor device (for instance a photovoltaic device) may comprise the following layers in the following order:
I. one or more first electrodes which comprise a transparent conducting oxide, preferably FTO;
II. an n-type region comprising at least one n-type layer as defined herein;
III. a layer of the semiconducting material as defined herein;
IV. a p-type region comprising at least one p-type layer as defined herein; and
V. one or more second electrodes which comprise a metal, preferably silver or gold.

The one or more first electrodes may have a thickness of from 100 nm to 700 nm, for instance of from 100 nm to 400 nm. The one or more second electrodes may have a thickness of from 10 nm to 500 nm, for instance from 50 nm to 200 nm or from 10 nm to 50 nm. The n-type region may have a thickness of from 50 nm to 500 nm. The p-type region may have a thickness of from 50 nm to 500 nm.

### Process

The invention also provides a process for producing a crystalline compound as defined herein, which process comprises contacting: (i) InX; (ii) B^{III}X'₃; and (iii) AX", wherein: each of X, X' and X" is the same or different and is a halide anion; A is an organic monocation; and B^{III} is Bi³⁺ or Sb³⁺.

Typically, X, X' and X" are the same and are a halide ion which is I⁻, Br⁻ and Cl⁻. Preferably, X, X' and X" are the same and are each Br⁻.

A may be as defined above and is typically (CH₃NH₃)⁺ or (H₂N-C(H)=NH₂)⁺. B^{III} is typically Bi³⁺.

In some cases, the process may comprise contacting (i) InX; (ii) B^{III}X₃; (iii) AX; and (iv) A'X, where A' is a further first cation (which is different from A). The further first cation is typically Cs⁺, (CH₃NH₃)⁺ or (H₂N-C(H)=NH₂)⁺. For instance, the process may comprise contacting (i) InBr; (ii) BiBr₃; (iii) (CH₃NH₃)Br or (H₂N-C(H)=NH₂)Br; and optionally (iv) CsBr.

Contacting the components typically comprises allowing the components to react. For instance, solid powders of components (i) to (iii) and optionally (iv) can be combined and heated. The components may be heated to a temperature of from 50°C to 400°C, for instance from 150°C to 250°C. The time taken to heat the components to the temperature may be from 0.1 to 6 hours. The components may be heated at the temperature for from 0.5 to 20 hours. Typically, the components are combined and heated under low pressure (for instance less than or equal to 10⁻³ mbar). This may be done in a sealed ampoule. After heating, the reaction product is typically cooled to room temperature.

Alternatively, components (i) to (iii) and optionally (iv) can be reacted in the solution phase. For instance, the components may be dissolved together in a solvent. Alternatively, a first solution comprising one or more of the components and a first solvent may be combined with a second solution comprising the other components and a second solvent. The solvents may be any suitable solvents. For instance, the solvents may be selected from water, methanol, ethanol, dimethylformamide (DMF), benzene, toluene, dichloromethane and chlorobenzene. Typically, the solvent is DMF. After contacting components (i) to (iii) and optionally (iv), the solvent is typically removed. The solvent may be removed by filtration or evaporation (including allowing the solvent to evaporate).

The crystalline compound may be produced by a hydrothermal method. For instance, components (i) to (iii) and optionally (iv) may be dissolved together in a solvent, for instance DMF. The solution may then be heated at a temperature from 50°C to 400°C, for instance from 100°C to 200°C. The components may be heated at the temperature for from 1 to 48 hours. Typically, the composition comprising the components and the solvent is heated in an autoclave. After heating, the reaction product is typically cooled to room temperature. The reaction product may then be isolated from the solvent by filtration or by allowing the solvent to evaporate.

The molar ratio of components (i), (ii) and (iii) (and if present (iv)) is typically a:b:c where a is the amount of (i), b is the amount of (ii) and c is the amount of (iii) and, if present, (iv) and where a is from 0.5 to 1.5, b is from 0.5 to 1.5 and c is from 1.0 to 3.0. For instance, a:b:c may be approximately 1:1:2.

The process may be a process for producing a layer of a crystalline compound and which process comprises disposing on a substrate a precursor composition comprising: (i) InX; (ii) B^{III}X'₃; and (iii) AX". The precursor composition typically further comprises a solvent. The solvent is typically removed after deposition of the precursor composition on the substrate, for instance by heating the substrate. The precursor composition may be disposed by any suitable method, for instance by spin-coating. In place of the precursor composition, a composition comprising the crystalline compound may be disposed on the substrate. For instance, the composition may comprise a solution or suspension of the crystalline compound in a solvent.

Alternatively, the crystalline compound, or the precursor components (i) InX; (ii) B^{III}X'₃; and (iii) AX", may be disposed on the substrate by vapour deposition. For instance, the substrate may be exposed to a vapour comprising the crystalline compound or to a vapour comprising (i) InX; (ii) B^{III}X'₃; and (iii) AX" for a time sufficient to form a layer of the crystalline compound.

The layer may have a thickness of from 5 nm to 5000 nm, for instance from 100 nm to 700 nm. The substrate may comprise a first electrode material as defined herein. The substrate may comprise a n-type layer or a p-type layer as defined herein.

The invention also provides a process for producing a semiconductor device, which process comprises a process for producing a crystalline compound according to the invention. Typically, the process for producing a semiconductor device comprises disposing on a substrate a composition comprising a solvent and (i) InX; (ii) B^{III}X'₃; and (iii) AX". The solvent is typically removed after deposition of the precursor composition on the substrate, for instance by heating the substrate.

The invention will be described further by the following Examples.

### EXAMPLES

### Example 1 - Computational study

### Computational methods

Density functional theory (DFT) calculations were performed using Quantum ESPRESSO and VASP. For structural properties the generalized gradient approximation (PBE) or the local density approximations (LDA) exchange and correlation was employed. For band structures the PBE0 functional was used. The projector augmented wave (PAW) method was employed in VASP, and ultra-soft (US) pseudopotentials were employed in Quantum ESPRESSO. In 4d semicore states were included in all calculations, and all band structures were fully relativistic. The following planewaves kinetic energy cutoffs were employed: 38 Ry for PAW/LDA, 38 Ry for PAW/PBE, 40 Ry for US/LDA, 40 Ry for US/PBE and 22 Ry for the PAW/PBE0. The Brillouin zone was sampled as follows: 153 Γ-centered grid for the structural relaxations; 63 grid for the PBE0 calculations; 153 grid for optical absorption. The band structures were calculated using DFT/PBE, and scissor-corrected using the PBE0 gaps. The effective masses were calculated using fully-relativistic DFT/PBE0 using finite differences. The calculation of the absorption coefficient was performed within the independent-particle approximation, using YAMBO, the LDA, and fully-relativistic norm-conserving pseudopotentials; the spectra were scissor-corrected using the PBE0 gaps. The decomposition pathways were identified using Pymatgen and the Materials Project, and all energies except those marked by asterisks in Table 1 are from the Materials Project.

### Results and discussion

Computational methods were used to examine possible candidates for B⁺ and B³⁺ in A₂BB'X₆ double perovskite compounds. For this, all the elements that are found in elpasolites were considered in turn. For the B³⁺ site the possibilities include (i) several transition metals (Sc-Cu, Y and Au), (ii) the lanthanides, (iii) some actinides (Pu, Am and Bk), (iv) the elements of Group III, and (v) the pnictogens. Among these candidates, transition metals, lanthanides, and actinides have partially-occupied d or f orbitals and it would be expected to find such states at the band extrema. Similarly, elements belonging to Group III will have the highest occupied states of d character in their +3 oxidation state and d states would be expected at the top of the valence band. Pnictogens stand out in this list, because in their +3 state they have occupied s and d shell and unoccupied p shell, with the d electrons deeper than the s electrons. Therefore in this case, s states are expected at the valence band top, and p states at the conduction band bottom. This is analogous to what happens in MAPbI₃. Among the pnictogens, N³⁺ and P³⁺ are very small cations, and as a result they would not be stable in a perovskite structure according to Goldschmidt's rules (Goldschmidt's octahedral factors of 0.12 and 0.34 for NF₆ and PF₆ octahedra were calculated, respectively, well below the stability limit of 0.41). Arsenic is toxic, and as such it is not a good alternative to Pb. Thus, the two larger member of the pnictogen family, Sb³⁺ and Bi³⁺, were identified as promising candidates to realize double perovskites with electronic structure similar to MAPbI₃.

For the B⁺ site in A₂BB'X₆, the possible candidates are (i) the alkali metals, (ii) the noble metals, and (iii) the elements of Group III. Alkali metals usually lead to non dispersive bands and are unlikely to be useful in the present context. Cations of noble metals in the +1 oxidation state have the highest occupied orbitals of d-character. This is expected to lead to valence band maxima of d character, which is not desirable. On the other hand, the elements of Group III in their +1 oxidation state have filled s and d shells, with d electrons deeper than s electrons. This configuration is analogous to the case of Pb in MAPbI₃ and is therefore desirable. Among Group III elements, the +1 oxidation state tends to be stable only for the largest members of the group. For example In and T1 can be found in the +1 state, while Ga can be found in the +1 state only at high temperature. Since T1 is toxic, In+ is the most promising candidate for the B⁺ site in lead-free materials.

The stability, electronic, and optical properties of double perovskites of the type A₂InBiX₆ and A₂InSbX₆ were investigated with A = K, Rb or Cs, and X = F, Cl, Br or I. The empirical Goldschmidt's structure factors, namely the octahedral factor µ = rB/rX and the tolerance factor t = (rA + rB)/√2(rB + rX), with rA, rB, and rX denoting ionic radii were first examined. The octahedral factor for each type of octahedron were considered and the ionic radii of the B and B' sites were averaged for the tolerance factor. Of the 36 hypothetical structures considered, all In/X and Bi/X combinations pass the octahedral factor test (µ > 0.41), as well as the combinations Sb/F and Sb/Cl, while Sb/Br and Sb/I are to be discarded. All these combinations pass the tolerance factor test (0.75 < t < 1.0). This pre-screening leaves 18 potential double perovskites. First-principles calculations were then performed to investigate the stability of these 18 hypothetical compounds against decomposition. The Materials Project database was interrogated (Jain et al, APL Mater. 2013, 1, 011002) and compare all possible decomposition pathways, as shown in Table 1. Table 1 shows decomposition energies (ΔE) and associated decomposition pathways of hypothetical In/Bi and In/Sb halide double perovskite. The decomposition pathways are generated from the Materials Project database. The asterisk denotes a decomposition route where the reaction products are not reported in the Materials Project of the Inorganic Crystal Structure Database (ICSD). A negative number indicates that the structure is predicted to decompose.

**Table 1**

| Compound | ΔE (meV/atom) | Decomposition Pathway |
|---|---|---|
| K₂InSbF₆ | -163 | 4/15 KIn₂F₇ + 1/3 KSbF₄ + 7/15 K₃InF₆ + 2/3 Sb |
| K₂InSbCl₆ | -95 | 7/15 SbCl₃ + 1/15 In₅Cl₉ + 2/3 K₃InCl₆ + 8/15 Sb |
| Rb₂InSbF₆ | -73 | 1/3 Rb₂In₃F₁₁ + 7/6 RbF+1/6 RbSb₂F₇ + 2/3 Sb |
| Rb₂InSbCl₆ | -58* | 1/2 Rb₃In₂Cl₉ + 1/6 Rb₃Sb₂Cl₉ + 2/3 Sb |
| Cs₂InSbF₆ | -17 | 2/5 CsF+4/5 CsInF₃ + 4/5 CsSbF₄ + 1/5 InSb |
| C_{S2}InSbCl₆ | -57 | 1/2 Cs₃In₂Cl₉ + 1/6 Cs₃Sb₂Cl₉ + 2/3 Sb |
| K₂InBiF₆ | -134 | 1/3 KInF₇ + 1/3 K₂BiF₅ + 1/3 K₃InF₆ + 2/3 Bi |
| K₂InBiCl₆ | -61 | 3/22 Bi₆CI₇ + 2/11 BiCl₃ + 1/6 In₂Cl₃ + 2/3 K₃InCl₆ |
| K₂InBiBr₆ | -60 | 1/3 BiBr₃+KInBr₄+KBr+2/3 Bi |
| K₂InBiI₆ | -64 | 2KI+InI+BiI₃ |
| Rb₂InBiF₆ | -42 | 1/3 RbBiF₄+RbF+1/3 Rb₂In₃F11 + 2/3 Bi |
| Rb₂InBiCl₆ | -43* | 1/2 Rb₃In₂Cl₉ + 1/6 Rb₃Bi₂Cl₉ + 2/3 Bi |
| Rb₂InBiBr₆ | -26 | 2/3 Rb₃BiBr₆+InBr₂ + 1/3 Bi |
| Rb₂InBiI₆ | -36 | 1/6 Rb₃Bi₂I₉ + 1/2 RbI+RbInI₄ + 2/3 Bi |
| Cs₂InBiF₆ | -28* | 1/2 Cs₃In₂F₉ + 1/6 Cs₃Bi₂F₉ + 2/3 Bi |
| Cs₂InBiCl₆ | -24 | 1/2 Cs₃In₂Cl₉ + 1/6 Cs₃Bi₂Cl₉ + 2/3 Bi |
| Cs₂InBiBr₆ | -1* | 1/2 Cs₃In₂Br₉ + 1/6 Cs₃Bi₂Br₉ + 2/3 Bi |
| Cs₂InBiI₆ | -12 | 1/2 CsI+1/2 Cs₃Bi₂I₉+InI |
| Fr₂InBiBr₆ | 7 | 1/2 Fr₃In₂Br₉ + 1/6 Fr₃Bi₂Br₉ + 2/3 Bi |

Most of the hypothetical double perovskites considered here are found to be unstable within the compound space of the Materials Project database, with the exception of Rb₂InSbCl₆, Rb₂InBiCl₆, Cs₂InBiF₆ and Cs₂InBiBr₆. It need also to be considered that the compounds may decompose into reaction products that may not be included in the Materials Project or even in the Inorganic Crystal Structure Database, ICSD. This is especially important since the redox mechanism of In in these compounds was shown to play a key role (Xiao et al, J. Am. Chem. Soc. 2017, 139, 6054-6057).

In order to address this lack of information, the total energies of hypothetical A₃B₂X₉ compounds with A = Rb, Cs, B = In, Sb, Bi, and X = F, Cl, Br were calculated. These compounds were selected in order to complete the Materials Project data in Table 1 with all possible combinations of A, B, and X. In the calculations, the assumption that these compounds have the same crystal structure as Cs₃Bi₂Br₉ (Aleksandrova et al, Phase Transit. 2002, 75, 607-620) was made and that A₃In₂X₉ compounds have the same structure as Cs₃In₂Cl₉ (Meyer, Z. Anor. Allg Chem. 1978, 445, 140-146). The decomposition pathways involving hypothetical reaction products are indicated by an asterisk in Table 1. After including these additional reactions, the disappointing result was obtained that most halide double perovskites A₂InBiX₆ and A₂InSbX₆ with A = K, Rb or Cs, and X = F, Cl, Br or I will tend to spontaneously decompose into compounds where In is in its +3 oxidation state.

Among all the hypothetical double perovskites considered, Cs₂InBiBr₆ exhibits the smallest decomposition energy, 1 meV/atom. The very close proximity of this compound to a stable phase suggests that a slightly-modified version of Cs₂InBiBr₆ might be amenable to synthesis. In order to test this hypothesis, the trends of the decomposition energies as a function of the A-site, B-site, and X-site ions were investigated.

Surprisingly, Figure 1a shows that the energy gain of the reaction A₂InBiBr₆ → 1/2 A₃In₂Br₉ + 1/6 A₃Bi₂Br₉ + 2/3 Bi decreases as the size of the A-site cation increases. The calculations were repeated using either the local density approximations (LDA) to density functional theory (DFT) or the generalized gradient approximation (PBE), as well as using either ultra-soft (US) pseudopotentials or the projector augmented wave (PAW) method, as described in the computational methods section. The trend in Figure 1a indicates that it should be possible to stabilize these double perovskites by using A-site cations larger than Cs. In particular, by extrapolating the curve of decomposition energy vs. the ionic radius of the A cation, it was found that the organic cations used in the best photovoltaic perovskites, such as MA and FA (rA = 2.2 Å and 2.5 Å, respectively), should yield structures which are stable against decomposition.

The calculation of phase diagrams of hybrid organic-inorganic perovskites is very challenging due to the sensitivity of the results to the orientation of the organic cations, as well as the lack of detailed structural information on the molecular salt precursors. This difficulty was circumvented by performing a calculation on the *"hypothetical"* double perovskite Fr₂InBiBr₆. Fr is radioactive and is not suitable for this applications. However, it represents a useful model as it is the only +1 elemental cation with an ionic radius larger than Cs. By performing total energy calculations it was found that the replacement of Cs by Fr improves the stability of the double perovskite with respect to decomposition, thereby validating the trend anticipated in Figure 1a. This calculation demonstrates that indeed larger cations should improve the stability of the halide double perovskite A₂InBiBr₆. Owing to the small decomposition energies shown in Figure 1a, the sensitivity of the total energy of the hybrid perovskites to the orientation of the organic molecules, and the lack of experimentally-determined structures of their decomposition products, currently it is not possible to calculate the decomposition energies of hybrid halide double perovskites.

For completeness empirical tolerance factors are shown in Figure 1b. This shows that all the compounds fall within the empirical stability region, with FA lying at the edge of this region. These findings indicate that mixes of MA₂InBiBr₆ and FA2InBiBr₆, and even possibly with a small fraction of Cs₂InBiBr₆, should be amenable to synthesis.

Following identification of the most promising compositions to achieve stable double perovskites without d states at the band edges, analysis of their electronic and optical properties was carried out. Starting from Fr₂InBiBr₆ as the simplest compound that is expected to be chemically stable (even though Fr cannot be used for real applications), the structure in the elpasolite lattice was optimised with space group Fm3m. The electronic band structure at the DFT/PBE0 level is shown in Figure 2a. Highly dispersive bands were found, with small, isotropic, and balanced effective masses: m*ₕ =0.07 mₑ , m*ₑ =0.08 mₑ. These values are comparable with those of MAPbI₃. The dispersive character of the bands is a result of the continuous over-lap between In-5s, Bi-6p; -Br-4p states in the valence, and In-5p, Bi-6p, Br-4p states in the conduction (see the molecular orbital diagram in Figure 2b). In contrast to In/Ag halide double perovskites (Volonakis et al, J Phys. Chem. Lett. 2017, 8, 772-778) here the wavefunctions exhibit a distinctly three-dimensional character, as shown in Figure 2c.

Having established that the electronic structure of Fr₂InBiBr₆ is very similar to MAPbI3, the hybrid double perovskite MA₂InBiBr₆ was then investigated. In this case the orientation of the organic cations is well-known to lead to artefacts such as unphysical distortions of the octahedra, artificial ferroelectric polarization, and artificial breaking of inversion symmetry, leading to Rashba-type spin-orbit splitting of the bands (Frost et al, Nano Lett. 2014, 5, 2584; Brivio et al, Phys. Rev. B 2014, 89, 155204). In order to avoid these artefacts, the structural data available for the low-temperature orthorhombic *Pnma* phase of MAPbI₃ (Baikie et al, J. Chem. Mater. A 2013, 1, 5628) was used with the replacement of the four Pb atoms in the unit cell with Bi and In, alternating in a rock-salt sublattice. The optimized structure is shown in Figure 3a. It was found that MA₂InBiBr₆ retains similar octahedral tilt angles as MAPbI₃, and the unit-cell volume is only slightly smaller. The BiBr₆ octahedra are found to be slightly smaller than InBr₆ octahedra (the BX bond lengths are 2.9 Å vs. 3.3-3.4 Å, respectively). The band structure of MA₂InBiBr₆ is shown in Figure 3, alongside the band structure of MAPbI₃ for comparison. The calculated band gap of MAPbI₃ is 1.9 eV within DFT/PBE0, in good agreement with higher-level calculations and experiment. The band gap of MA₂InBiBr₆ within the same level of approximation is only slightly larger, 2.0 eV. Band gaps tend to be larger in the presence of octahedral tilts and the high-temperature cubic structures are expected to exhibit smaller gaps. The calculated effective masses of MAPbI₃ and MA₂InBiBr₆ (optimized using DFT/PBE) are very similar, in fact 0.22/0.16 mₑ and 0.23/0.26 mₑ was found for holes/electrons in the two compounds, respectively. These masses are slightly heavier that those reported for the Fm3m structures, due to the octahedral tilt.

Figure 3b shows the calculated optical absorption spectrum of MA₂InBiBr6, as well as calculations for prototypical photovoltaic materials such as Si, GaAs, and MAPbI₃. It is evident that MA₂InBiBr₆ is a strong optical absorber, and behaves in a similar manner to MAPbI₃. The similarity between the electronic and optical properties of MAPbI₃ and MA₂InBiBr₆ shown in Figure 3 provides a strong validation of the design rules discussed in this Example. In order to probe the effects of mixing cations at the A site, we construct models of (Cs_{0.5}MA_{0.5})₂InBiBr₆ and (MA_{0.5}FA_{0.5})2InBiBr6 by replacing two out of four MA cations in MA₂InBiBr₆ with Cs or FA, respectively. The two types of cations were alternated in a rock-salt A-site sublattice so as to maintain inversion symmetry. The optimized model structures are shown in Figure 3c. The band structure of these compounds (Figure 3c) remains very similar to that of MAPbI₃, with band gaps of 1.7 eV I(Cs_{0.5}MA_{0.5})₂InBiBr₆] and 1.9 eV [(FA_{0.5}MA_{0.5})₂InBiBr₆]. This suggests that, on top of being stable against decomposition, mixed-cation double perovskites should also offer band gap tunability across the visible range, as in the case of (Cs/MA/FA)PbI₃ (McMeekin et al, Science 2016, 8, 151- 155; Eperon et al, Science 2016, 354, 861-865).

In conclusion, a promising pathway to synthesis of stable lead-free halide double perovskites with optoelectronic properties comparable to those of MAPbI₃ has been identified. In particular, the mixed cation double perovskite (Cs/MA/FA)₂InBiBr₆ has been identified as a potential replacement for MAPbI₃. The surprising finding is that the most problematic instability, namely the oxidation of In⁺ into In³⁺, becomes energetically less favourable as the size of the A-site cation increases.

### Example 2 - Synthetic study

### Synthesis of (HC(NH₂)₂)₂In^{(I)}B^{(III)}Br₆

*Solid-state synthesis:* For a typical reaction, the starting materials HC(NH₂)₂Br (Dyesol, 99.9%), BiBr₃ (Sigma Aldrich, 99.99%) and InBr (Sigma Aldrich, 99%) were mixed in a molar ratio 2:1:1, respectively. A mixture of 1.0 g BiBr₃, 0.55 g FABr and 0.434 g of InBr was loaded into a borosilicate glass ampoule that was then flame sealed under vacuum (10⁻³ mbar). The mixture was heated to 180°C in 4 hours and maintained at this temperature for 8 hours, before cooling to room-temperature. After cooling to room temperature, a yellow/greenish polycrystalline material was observed that upon grinding appeared more greenish.

### Synthesis of (CH₃NH₃)₂In^{(I)}Bi^{(III)}Br₆

*Solid-state synthesis:* the process is similar to the synthesis of (HC(NH₂)₂)₂In^{(I)}Bi^{(III)}Br₆ described above. MABr (Dyesol, 99.9%) was used. A mixture of 1.0 g BiBr₃, 0.534 g MABr and 0.434 g of InBr was loaded into a borosilicate glass ampoule that was then sealed in vaccuo (10⁻³ mbar). The mixture was heated to 200°C in 4 hours and kept at this temperature for another 8 hours before cooling to room-temperature. After cooling to room-temperature the material was yellow/orange while in the ampoule. Upon heating the material to 250°C for 4 hours, the material turned dark and the yellow disappeared.

### Synthesis by hydrothermal method

For the synthesis of (HC(NH₂)₂)₂In^{(I)}Bi^{(III)}Br₆, the synthetic route described in Wei et al, Mater. Horiz. 3, 328, (2016) was followed, i.e. the hydrothermal synthesis of MA₂KBiCl₆ with some modifications regarding the type of solvent used. FABr, InBr and BiBr₃ were mixed at a molar ratio of 2:1:1 in a dimethylformamide (DMF) solution and the mixture was then poured into a Teflon beaker that was enclosed by a stainless steel autoclave. The autoclave was put in a box furnace and heated up to 150°C for 24 hours before cooling to room temperature. The product obtained had formed a white precipitate with a brownish solvent on the top of it.

### Structural characterisation

Powder X-ray diffraction was carried out using a Panalytical X'pert powder diffractometer (Cu-K_{α1} radiation; X = 154.05 pm) at room temperature for the product of the reaction of FABr, InBr and BiBr₃. Structural parameters were obtained by Rietveld refinement using General Structural Analysis Software. Figure 4 shows the room-temperature PXRD pattern of the precursors FABr, InBr and BiBr₃ after solid-state reaction. The powder diffraction peaks were indexed assuming a single phase compound has formed and find the following cell parameters: a = 8.5046 Å; b= 8.5046 Å; c= 13.5093 Å; α = 90.0°; β= 90.0°; γ= 120.0°.

Assuming the above cell parameters, a search on the Inorganic Crystals Structure Database found a compound with similar cell parameters, which was reported as (NH₂(CH₃)₂)(Fe₂ (HCOO)₆). This indicates that FA₂BiInBr₆ has been formed.

## Claims

1. A crystalline compound, which crystalline compound comprises:
(i) an organic monocation;
(ii) In⁺;
(iii) Bi³⁺ or Sb³⁺; and
(iv) a halide anion.

2. A crystalline compound according to claim 1, wherein the crystalline compound comprises:
(i) one or more first monocations [A], which one or more first monocations comprise the organic monocation;
(ii) one or more second monocations [B^{I}], which one or more second monocations comprise In⁺;
(iii) one or more trications [B^{III}], which one or more trications comprise Bi³⁺ or Sb³⁺; and
(iv) one or more halide anions [X].

3. A crystalline compound according to claim 1 or 2, wherein the one or more first monocations [A] are selected from Cs⁺, (NR¹R²R ³R⁴)⁺, (R¹R²N=CR³R⁴)⁺, (R¹R²N-C(R⁵)=NR³R⁴)⁺ and (R¹R²N-C(NR⁵R⁶)=NR³R⁴)⁺, wherein each of R¹, R², R³, R⁴, R⁵ and R⁶ is independently H, a substituted or unsubstituted C₁₋₂₀ alkyl group or a substituted or unsubstituted aryl group,
preferably wherein the one or more first monocations [A] are selected from (CH₃NH₃)⁺, (CH₃CH₂NH₃)⁺, (H₂N-C(H)=NH₂)⁺ and (H₂N-C(NH₂)=NH₂)⁺.

4. A crystalline compound according to any one of the preceding claims, wherein the one or more trications [B^{III}] comprise Bi³⁺.

5. A crystalline compound according to any one of the preceding claims, wherein the one or more halide anions [X] are selected from I⁻, Br⁻ and Cl⁻,
preferably wherein the one or more halide anions [X] are a single halide anion which is Br⁻.

6. A crystalline compound according to any one of the preceding claims, wherein the crystalline compound is a compound of formula (I):
[A]₂[B^{I}][B^{III}][X]₆ (I);
wherein:
[A] is the one or more first monocations;
[B^{I}] is the one or more second monocations;
[B^{III}] is the one or more trications; and
[X] is the one or more halide anions.

7. A crystalline compound according to any one of the preceding claims, wherein the crystalline compound is a compound of formula (Ib):
(A'ₓA"₍₁₋ₓ₎)₂InSb_{q}Bi_{(1-q)}[X]₆ (Ib);
wherein:
A' is the organic monocation;
A" is a further monocation;
x is from 0.1 to 1.0;
q is from 0.0 to 1.0; and
[X] is the one or more halide anions,
optionally wherein the further monocation is Cs⁺, NH₄⁺, (CH₃NH₃)⁺ or (H₂N-C(H)=NH₂)⁺.

8. A crystalline compound according to any one of the preceding claims, wherein the compound is a compound of formula (Ic):
A₂InB^{III}[X]₆ (Ic);
wherein:
A is the organic monocation;
B^{III} is Bi³⁺ or Sb³⁺; and
[X] is the one or more halide anions.

9. A crystalline compound according to any one of the preceding claims, wherein the crystalline compound is (H₂N-C(H)=NH₂)₂InBiI₆, (H₂N-C(H)=NH₂)₂InSbI₆, (H₂N-C(H)=NH₂)₂InBiBr₆, (H₂N-C(H)=NH₂)₂InSbBr₆, (H₂N-C(H)=NH₂)₂InBiCl₆, (H₂N-C(H)=NH₂)₂InSbCl₆, (CH₃NH₃)₂InBiI₆, (CH₃NH₃)₂InSbI₆, (CH₃NH₃)₂InBiBr₆, (CH₃NH₃)₂InSbBr₆, (CH₃NH₃)₂InBiC]₆ or (CH₃NH₃)₂InSbCl₆,
preferably wherein the crystalline compound is (H₂N-C(H)=NH₂)₂InBiBr₆ or (CH₃NH₃)₂InBiBr₆.

10. A crystalline compound according to any one of claims 1 to 5, wherein the compound is a compound of formula (III):
[A]₂[B^{I}]_{(2-z)/2}[B^{II}]_{z}[B^{III}]_{(2-z)/2}[X]₆ (III);
wherein:
[A] is the one or more first monocations;
[B^{I}] is the one or more second monocations;
[B^{II}] is one or more metal dications, optionally selected from Pb²⁺ and Sn²⁺;
[B^{III}] is the one or more trications;
[X] is the one or more halide anions; and
z is from 0.01 to 1.99.

11. A semiconducting material comprising a crystalline compound as defined in any one of the preceding claims,
preferably wherein the semiconducting material comprises at least 80% by weight of the crystalline compound,
more preferably wherein the semiconducting material is in the form of a layer, which layer has a thickness of from 5 nm to 5000 nm.

12. A semiconductor device comprising a semiconducting material, which semiconducting material comprises a crystalline compound, which crystalline compound comprises:
(i) an organic monocation;
(ii) In⁺;
(iii) Bi³⁺ or Sb³⁺; and
(iv) a halide anion.

13. A semiconductor device according to any claim 12, wherein the semiconductor device comprises:
an n-type region comprising at least one n-type layer;
a p-type region comprising at least one p-type layer; and, disposed between the n-type region and the p-type region:
a layer of the semiconducting material.

14. A process for producing a crystalline compound as defined in any one of claims 1 to 10, which process comprises contacting:
(i) InX;
(ii) B^{III}X'₃; and
(iii) AX",
wherein:
each of X, X' and X" is the same or different and is a halide anion; and
B^{III} is Bi³⁺ or Sb³⁺.

15. A process for producing a semiconductor device, which process comprises a process for producing a crystalline compound as defined in claim 14.
